Europäisches Patentamt

European Patent Office

Office européen des brevets

(11) Publication number: **0 452 874 A2**

# EUROPEAN PATENT APPLICATION

(21) Application number: 91106041.6

(22) Date of filing: 16.04.91

(51) Int. Cl.⁵: **H01L 27/092, H01L 27/06**

(30) Priority: 16.04.90 JP 99632/90

(43) Date of publication of application:
23.10.91 Bulletin 91/43

(84) Designated Contracting States:
**DE FR GB**

(71) Applicant: **Kabushiki Kaisha Toshiba**
**72, Horikawa-cho Saiwai-ku**
**Kawasaki-shi(JP)**

(72) Inventor: **Tsugaru, Kazunori, c/o Intellectual**
**Property Div.**
**Kabushiki Kaisha Toshiba, 1-1 Shibaura**
**1-chome**
**Minato-ku, Tokyo 105(JP)**

(74) Representative: **Lehn, Werner, Dipl.-Ing. et al**
**Hoffmann, Eitle & Partner Patentanwälte**
**Arabellastrasse 4**
**W-8000 München 81(DE)**

(54) MOS semiconductor device.

(57) According to this invention, there is disclosed a MOS semiconductor device including a semiconductor substrate (1) of a first conductivity type, first and second buried diffusion layers (2-1, 2-2) of a second conductivity type selectively formed on the substrate (1), an epitaxial layer (3) of the first conductivity type formed on the substrate (1) and the first and second buried diffusion layers (2-1, 2-2), a first well region (4-1) of the second conductivity type formed in the epitaxial layer (3) to be in contact with the first buried diffusion layer (2-1), a second ring-like well region (4-2) of the second conductivity type formed in the epitaxial layer (3) to be in contact with the second buried diffusion layer (2-2), a MOS transistor (10) of the first conductivity type formed in a surface layer of the first well region (4-1), and a MOS transistor (16) of the second conductivity type formed in a surface layer of a portion surrounded by the second well region (4-2) of the epitaxial layer (3).

F I G. 5

The present invention relates to a MOS semiconductor device requiring a high-speed operation.

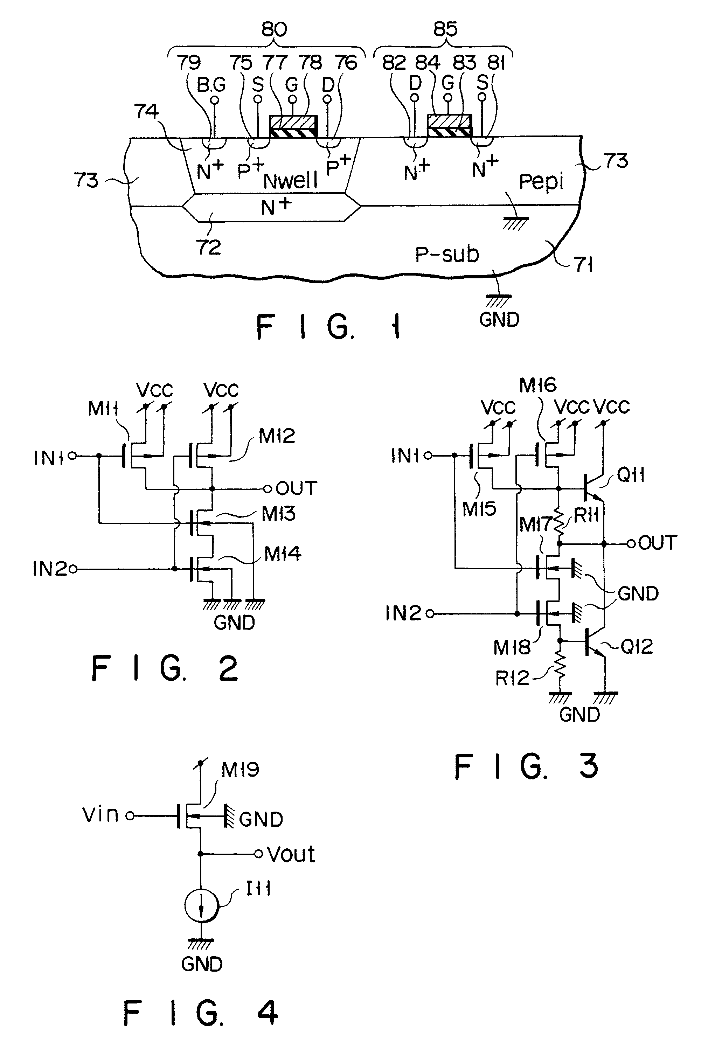

Fig. 1 is a sectional view showing an arrangement of a conventional MOS semiconductor device.

On a p-type silicon substrate 71, an $n^+$-type buried diffusion layer 72 is formed by doping a high-concentration n-type impurity, and a p-type epitaxial layer 73 is formed. In the epitaxial layer 73, an n-type well region 74 is formed on the $n^+$-type buried diffusion layer 72 to be in contact with the region 72.

$P^+$-type source and drain regions 75 and 76 are formed on the surface of the well region 74 by selectively doping a high-concentration p-type impurity. On the well region 74, a gate oxide film 77 and a gate electrode 78 are formed between the source and drain regions 75 and 76. On the surface of the well region 74, an $n^+$-type region 79 for controlling a backgate is formed near the source and drain regions 75 and 76. Thus, a p-channel MOSFET 80 can be obtained.

$N^+$-type source and drain regions 81 and 82 are selectively formed on the surface of the epitaxial layer 73. On the epitaxial layer 73, a gate oxide film 83 and a gate electrode 84 are formed between the source and drain regions 81 and 82. Thus, an n-channel MOSFET 85 can be obtained.

With the above arrangement, since the backgate of the n-channel MOSFET 85 is in electrical contact with the substrate 71, when the substrate 71 is set at a ground voltage GND, the backgate is always connected to the GND. For this reason, when the n-channel MOSFET is operated, current drivability is degraded due to a backgate effect, and a delay time is increased in an operation of a CMOS logic gate, a Bi-CMOS logic gate, or the like. In addition, in an analog circuit, an excess voltage may be required to be applied across a gate and a source. The above cases will be described in detail below.

Fig. 2 is a circuit diagram showing an arrangement of a CMOS logic gate, and this circuit is a 2-input NAND gate circuit. The backgates of the p-channel MOS transistors M11 and M12 for charging an output OUT are connected to a power source voltage Vcc. The backgates of the n-channel MOS transistors M13 and M14 for discharging the output OUT are necessarily connected to a ground voltage GND.

When an input terminal IN2 is set at "H" level, an input terminal IN1 is assumed to be changed from "L" level to "H" level. When the IN1 is inverted, the p-channel MOS transistor M11 to which a "H"-level potential is applied is turned off, and the n-channel MOS transistor M13 is turned on. Although the p-channel MOS transistor M12 having a gate to which the "H"-level potential of the IN2 is applied is set in an OFF state, the n-channel MOS transistor M14 is set in an ON state. Therefore, a through current I (not shown) is supplied from the Vcc to the GND in a switching operation of the input terminal IN1. The source voltage of the transistor M13 is increased from the GND level by $I \times R_{M4}$ ($R_{M4}$ is is an ON resistance of the transistor M14). At this time, since the backgate of the transistor M13 is connected to the GND, the backgate-source voltage $V_{BS}$ of the transistor M13 is decreased, and the current drivability is degraded due to a backgate effect, thereby increasing an operation delay time.

Fig. 3 is a circuit diagram showing an arrangement of a Bi-CMOS logic gate, and this circuit is a 2-input NAND gate circuit. An npn transistor Q11 for pulling up an output terminal OUT and an npn transistor Q12 for pulling down the output terminal OUT are added to the circuit having the arrangement in Fig. 2. That is, the collector and emitter of the transistor Q11 are connected to the power source voltage Vcc and the output terminal OUT, respectively, and the base of the transistor Q11 is connected to both the drains of the p-channel MOS transistors M15 and M16. A resistor R11 is connected between the base and emitter of the transistor Q11. The collector and emitter of the transistor Q12 are connected to the output terminal OUT and the ground voltage GND, respectively. An n-channel MOS transistor M17 having a gate connected to the input terminal IN1, an n-channel MOS transistor M18 having a gate connected to the input terminal IN2, and a resistor 12 are connected in series between the output terminal OUT and the ground potential GND. The base of the transistor Q12 is connected to the connection point between the transistor M18 and the resistor 12.

With the above arrangement, in order to turn on the transistor Q12 for pulling down the output, a base current must be supplied to the transistor Q12 by turning on the transistor M18. At this time, the source voltage of the transistor M18 is increased by the base-emitter voltage $V_{BEQ12}$ of the transistor Q12. In this case, the backgate of the transistor M18 is set at a GND level, thereby reducing an ability of supplying a current to the transistor Q12.

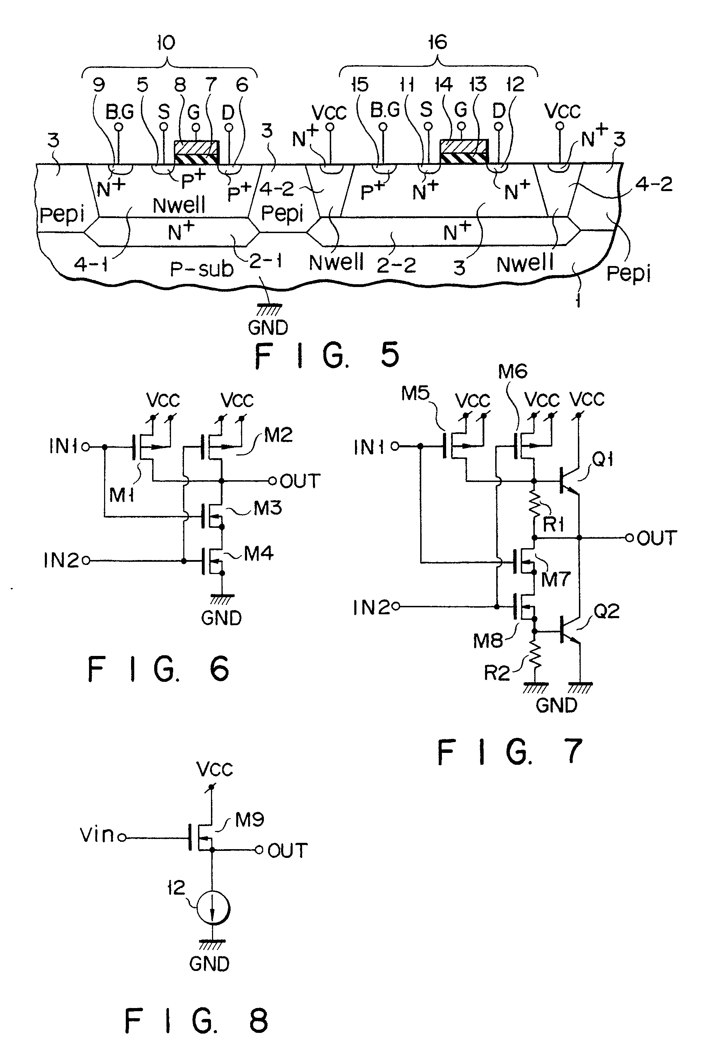

Fig. 4 is a circuit diagram showing an arrangement of an analog circuit, and this circuit is an NMOS source follower circuit. The drain of an n-channel MOS transistor M19 is connected to the power source voltage Vcc, the gate of the transistor M19 serves as an input terminal Vin to which an analog voltage is applied, and the source is connected to an output terminal Vout and to the ground voltage GND through a constant current source I11. Since the backgate is fixed at the ground potential GND, the gate-source voltage $V_{GS}$ of the transistor M19 is changed depending on the voltage of the input terminal Vin with respect to the constant current of the current source I11 by a backgate effect, and distortion occurs in the output voltage Vout. In addition, an extra gate-source voltage $V_{GS}$ (several hundred mV) is required with respect to the constant current of the current source I11.

As described above, the backgate of a conventional MOSFET is electrically connected to a substrate or other transistors through a channel. For this reason, a delay time is increased in an operation of a CMOS logic gate, a Bi-CMOs logic gate, or the like. In an analog circuit, a gate-source voltage is changed depending on an input level, and an extra gate-source voltage is disadvantageously required.

The present invention has been made in consideration of the above problem, and has as its object to provide a MOS semiconductor device capable of decreasing an operation delay time.

According to the present invention, a MOS semiconductor device comprises a semiconductor substrate of a first conductivity type, an epitaxial layer of a first conductivity type formed on the substrate, a buried diffusion layer of a second conductivity type selectively formed between the substrate and the epitaxial layer, a well region of the second conductivity type formed in the epitaxial layer to be in contact with the buried diffusion layer, and a MOS transistor of the second conductivity type formed in the epitaxial layer on the buried diffusion layer surrounded by the well region.

According to the present invention, a buried layer is formed between a substrate and an epitaxial layer, and the backgates of MOS transistors are separated from each other by forming a well region between the MOS transistors.

This invention can be more fully understood from the following detailed description when taken in conjunction with the accompanying drawings, in which:

Fig. 1 is a sectional view showing an arrangement of a conventional MOS semiconductor device;

Fig. 2 is a circuit diagram showing an arrangement of a conventional CMOS logic gate;

Fig. 3 is a circuit diagram showing an arrangement of a conventional Bi-CMOS logic gate;

Fig. 4 is a circuit diagram showing an arrangement of a conventional analog circuit;

Fig. 5 is a sectional view showing an arrangement of a semiconductor device according to the first embodiment of the present invention;

Fig. 6 is a circuit diagram showing an arrangement of a CMOS logic gate to which the present invention is applied;

Fig. 7 is a circuit diagram showing an arrangement of a Bi-CMOS logic gate to which the present invention is applied;

Fig. 8 is a circuit diagram showing an arrangement of an analog circuit to which the present invention is applied;

Fig. 9 is a sectional view showing an arrangement of a semiconductor device according to the second embodiment of the present invention; and

Fig. 10 is a sectional view showing an arrangement of a semiconductor device according to the third embodiment of the present invention.

Embodiments of the present invention will be described below with reference to the accompanying drawings.

Fig. 5 is a sectional view showing an arrangement of a MOS semiconductor device according to an embodiment of the present invention.

$N^+$-type buried diffusion layers 2-1 and 2-2 are formed on a p-type silicon substrate 1 by doping a high-concentration n-type impurity. A p-type epitaxial layer 3 is formed on the substrate 1 and the buried diffusion layers 2-1 and 2-2. In the epitaxial layer 3, an n-type well region 4-1 is formed on the $n^+$-type buried diffusion layer 2-1 to be in contact with the region 2-1.

A $p^+$-type source region 5 and a drain region 6 are formed by selectively doping a high-concentration p-type impurity in the surface layer of the well region 4-1. A gate oxide film 7 and a gate electrode 8 are formed across the source region 5 and the drain region 6. On the surface of the well region 4-1, an $n^+$-type region 9 for controlling a backgate voltage is formed near the source and drain regions 5 and 6. Thus, a p-channel MOSFET 10 can be obtained.

$N^+$-type source and drain regions 11 and 12 are selectively formed in the surface of the epitaxial layer 3 on the $n^+$-type buried diffusion layer 2-2. On the epitaxial layer 3, a gate oxide film 13 and a gate electrode 14 are formed between the source region 11 and the drain region 12. In the surface of the epitaxial layer 3, a $p^+$-type region 15 for controlling a backgate voltage is formed near the source and drain regions 11 and 12. Thus, an n-channel MOSFET 16 is obtained. In addition, a ring-like n-type well region 4-2 is formed to insulate the element region for forming the MOSFET 16 from the substrate 1 and other transistors such as the MOSFET 10. The well region 4-2 is formed such that its bottom portion is in contact with the $n^+$-type buried diffusion layer 2-2 and surrounds the element region of the MOSFET 16. The well region 4-2 is connected to, e.g., a power source voltage Vcc.

With the above arrangement, since the backgate of the n-channel MOSFET 16 is separated from the epitaxial layer 3, the substrate 1 generally connected to a ground voltage GND, and other transistors, the backgate voltage is changeable by a voltage applied to the $p^+$-type region 15. As a result, a delay time can be decreased in an operation of a CMOS logic gate or a Bi-CMOS logic gate or the like. In an analog circuit, the input level dependency of a gate-source voltage can be restrained, distortion can be prevented, and the gate-source voltage $V_{GS}$ can be decreased with respect to a constant drain voltage.

Circuits to which the present invention is applied will be described below.

Fig. 6 is a circuit diagram showing an arrangement of a CMOS logic gate using the present invention, and this circuit is a 2-input NAND gate circuit having the same circuit arrangement as described in Fig. 2. The other terminal of each of p-channel MOS transistors M1 and M2 each having one terminal connected to a power source voltage Vcc is connected to an output OUT. The gates of the transistors M1 and M2 are connected to input terminals IN1 and IN2, respectively. The backgates of the transistors M1 and M2 are connected to the power source voltage Vcc. N-channel MOS transistors M3 and M4 are connected in series between the output OUT and a ground voltage GND. The gates of the transistors M3 and M4 are connected to the input terminals IN1 and IN2, respectively. The backgate voltage of the transistor M3 has the same potential as its source voltage, and the backgate voltage of the transistor M4 has the same potential as its source voltage.

An operation of the circuit in Fig. 6 will be described below.

When the input IN2 is set at "H" level, the input terminal IN1 is changed from "L" level to "H" level. When the terminal IN1 is inverted, the transistor M1 is turned off, and the transistor M3 is turned on. Since the terminal IN2 is set at "H" level, the transistor M2 is set in an OFF state, and the n-channel MOS transistor M4 is set in an ON state. Therefore, the potential of the source of the transistor M3 is increased from a GND level by $I \times R_{M4}$ ($R_{M4}$ is an ON resistance of the transistor M4). In this case, since the potential of the backgate of the transistor M3 is equal to that of the source of the transistor M3, the backgate voltage does not degrade the current drivability of the transistor. Therefore, the operation delay time can be decreased.

When a logic operation of this circuit is tested by a SPICE (circuit simulator), the gate delay time is shortened from 180 ps to 160 ps compared with the circuit in Fig. 2.

Fig. 7 is a circuit diagram showing an arrangement of a Bi-CMOS logic gate. This circuit is a 2-input NAND gate circuit. An npn transistor Q1 for pulling up the output terminal OUT and an npn transistor Q2 for pulling down the output terminal OUT are added to the circuit having the arrangement described in Fig. 6. That is, the collector and emitter of the transistor Q1 are connected to the power source voltage Vcc and the output terminal OUT, respectively, and the base of the transistor Q1 is connected to both the drains of the p-channel MOS transistors M5 and M6. A resistor R1 is connected between the base and emitter of the transistor Q1. The collector and emitter of the transistor Q2 are connected to the output terminal OUT and the ground voltage GND, respectively, and the base of the transistor Q2 is connected to the source of an n-channel MOS transistor M8. A resistor R2 is connected between the base and emitter of the transistor Q2.

With the above arrangement, in order to turn on the transistor Q2 for pulling down the output, a base current must be supplied to the transistor Q2 by turning on the transistor M8. When the transistor M8 is turned on, the source voltage of the transistor M8 is increased by a base-emitter voltage $V_{BEQ2}$ of the transistor Q2. In this case, since the backgates of the transistors M7 and M8 have the same potentials as those of the sources thereof, the current drivability of the transistor M8 is not degraded, and the base current can be sufficiently supplied to the transistor Q2.

A logic operation of this circuit is tested by the SPICE, a gate delay time is shortened from 417 ps to 400 ps compared with the circuit in Fig. 3.

Fig. 8 is a circuit diagram showing an arrangement of an analog circuit, and this circuit is an NMOS source follower circuit. In this circuit, an n-channel MOS transistor M9 to which the present invention is applied is used in place of the n-channel MOS transistor M19 in Fig. 4. Since the backgate of the transistor M9 has the same potential as that of the source of the transistor M9, a gate-source voltage $V_{GS}$ can be decreased with respect to a constant current I2 compared with a case wherein the backgate is connected to the ground voltage GND. In addition, the input level dependency of the gate-source voltage $V_{GS}$ due to a backgate effect can be restrained, and the distortion of an output voltage Vout can be decreased.

In this circuit, when the gate-source voltage $V_{GS}$ of the transistor M9 is measured by the SPICE, the voltage is decreased from 1.582 V to 1.2238 V compared with the gate-source voltage of the transistor M19.

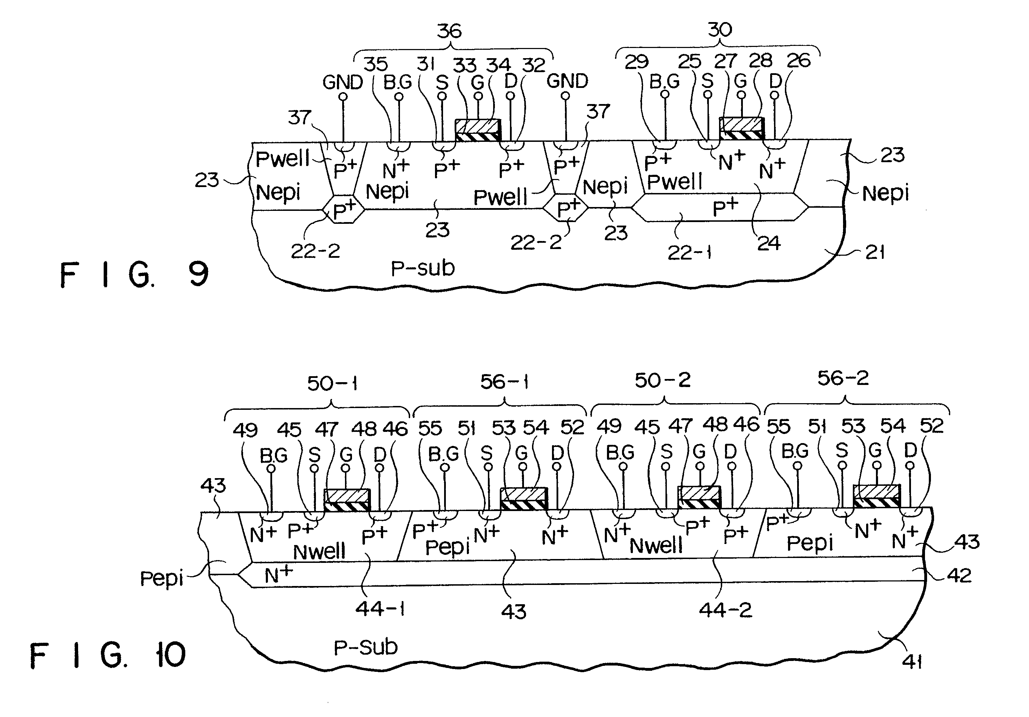

Fig. 9 is a sectional view showing an arrangement a semiconductor device according to the second embodiment of the present invention. The semiconductor device is a MOS semiconductor device in which an element is formed on an n-type epitaxial layer.

A $p^+$-type buried diffusion layer 22-1 and a ring-like $p^+$-type buried diffusion layer 22-2 are formed on a p-type silicon substrate 21 by selectively doping a high-concentration p-type impurity in predetermined portions. An n-type epitaxial layer 23 is formed on the silicon substrate 21 and $p^+$-type buried diffusion layers 22-1 and 22-2. In the epitaxial layer 23, a p-type well region 24 is formed on the $p^+$-type buried diffusion layer 22-1 to be in contact with the region 22-1.

$N^+$-type source and drain regions 25 and 26 are formed on the surface of the well region 24 by selectively doping a high-concentration n-type impurity. On the well region 24, a gate oxide film 27 and a gate electrode 28 are formed between the source and drain regions 25 and 26. In the surface of the well region 24, a $p^+$-type region 29 for controlling a backgate voltage is formed near the source and drain regions 25 and 26. Thus, an n-channel MOSFET 30 can be obtained.

A $p^+$-type source region 31 and a drain region 32 are selectively formed on the surface of the epitaxial layer 23 surrounded by the ring-like $p^+$-type buried diffusion layer 22-2. On the epitaxial layer 23, a gate oxide film 33 and a gate electrode 34 are formed between the source and drain regions 31 and 32. On the surface of the epitaxial layer 23, an $n^+$-type region 35 for controlling a backgate voltage is formed near the source and drain regions 31 and 32. Thus, a p-channel MOSFET 36 can be obtained. In addition, in order to isolate an element region for the MOSFET 36 from other transistors such as the MOS transistor 30, a ring-like p-type well region 37 is formed in the epitaxial layer 23 to surround the MOSFET 36. The well region 37 is in contact with the $P^+$-type buried diffusion layer 22-2. The well region 37 is connected to, e.g., a ground voltage GND.

With the above arrangement, as in Fig. 5, since the backgate of the p-channel MOSFET is separated from the substrate 21 generally connected to the ground potential, the epitaxial layer 23 connected to the power source voltage Vcc, and other transistors, the backgate voltage is changeable.

Fig. 10 is a sectional view showing an arrangement of a semiconductor device according to the third embodiment of the present invention, and this semiconductor device is a MOS semiconductor device in which a buried region is sequentially formed.

A high-concentration n-type impurity is doped in a MOS transistor forming region to form an $n^+$-type buried diffusion layer 42 on the p-type silicon substrate 41. An epitaxial layer 43 is formed on the silicon substrate 41 and the $n^+$-type buried diffusion layer 42. In the epitaxial layer 43 located on the $n^+$-type buried diffusion layer 42 n-type well regions 44-1 and 44-2 for forming a p-channel MOS transistor are formed thereon. The n-type well regions 44-1 and 44-2 are connected to the $n^+$-type buried diffusion layer 42.

In the surface of the well regions 44-1 and 44-2, $p^+$-type source and drain regions 45 and 46 are formed by selectively doping a high-concentration p-type impurity. On the well regions 44-1 and 44-2, a gate oxide film 47 and a gate electrode 48 are formed between the source and drain regions 45 and 46. In the surface of the well regions 44-1 and 44-2, an $n^+$-type region 49 for controlling a backgate voltage is formed near the source and drain regions 45 and 46. Thus, p-channel MOSFETs 50-1 and 50-2 can be obtained.

$N^+$-type source and drain regions 51 and 52 are selectively formed in the surface of the epitaxial layer 43. On the epitaxial layer 43, a gate oxide film 53 and a gate electrode 54 are formed between the source and drain regions 51 and 52. In addition, in the surface of the epitaxial layer 43, a $p+$-type region 55 is formed near the source and drain regions 51 and 52. Thus, n-channel MOSFETs 56-1 and 56-2 can be obtained.

With the above arrangement, as in Fig. 5, since a backgate of each element is separated from the epitaxial layer 43, the substrate 41 generally connected to the ground potential GND, and other transistors, the backgate voltage is changeable.

When various logic and analog circuits are arranged in accordance with the above embodiments in Figs. 9 and 10, as in Fig. 5, an operation delay time can be decreased.

As described above, according to the present invention, since the consumption of that a voltage required for an operation due to an effect of a backgate voltage is prevented, there is provided a MOS semiconductor device capable of decreasing an operation delay time.

Reference signs in the claims are intended for better understanding and shall not limit the scope.

## Claims

1. A MOS semiconductor device characterized by comprising:

   a semiconductor substrate (1) of a first conductivity type;

   first and second buried diffusion layers (2-1, 2-2) of a second conductivity type selectively formed on said substrate (1);

   an epitaxial layer (3) of the first conductivity type formed on said substrate (1) and said first and second buried diffusion layers (2-1, 2-2);

   a first well region (4-1) of the second conductivity type formed in said epitaxial layer (3) to be in contact with said first buried diffusion layer (2-1);

   a second ring-like well region (4-2) of the second conductivity type formed in said epitaxial layer (3) to be in contact with said second buried diffusion layer (2-2);

a MOS transistor (10) of the first conductivity type formed in a surface layer of said first well region (4-1); and

a MOS transistor (16) of the second conductivity type formed in a surface layer of a portion surrounded by said second well region (4-2) of said epitaxial layer (3).

2. A device according to claim 1, characterized in that said substrate (1) is separated from said MOS transistor (16) of the second conductivity type by said second buried diffusion layer (2-2), and said MOS transistor (10) of the first conductivity type is separated from said MOS transistor (10) of the second conductivity type by said second well region (4-2).

3. A device according to claim 1, characterized in that backgate voltages of said MOS transistor (10) of the first conductivity type and said MOS transistor (16) of the second conductivity type are changeable.

4. A MOS semiconductor device characterized by comprising:

a semiconductor substrate (21) of a first conductivity type;

a first buried diffusion layer (22-1) of the first conductivity type and a second ring-like buried diffusion layer (22-2) of a first conductivity type formed on said substrate (21);

an epitaxial layer (23) of the second conductivity type formed on said substrate (21) and said first and second diffusion layers (22-1, 22-2);

a first well region (24) of the first conductivity type formed in said epitaxial layer (23) to be in contact with said first buried diffusion layer (22-1);

a second ring-like well region (37) of the first conductivity type formed in said epitaxial layer (23) to be in contact with said second buried diffusion layer (22-2);

a MOS transistor (30) of a second conductivity type formed in a surface layer of said first well region (24); and

a MOS transistor (36) of the first conductivity type formed on a surface layer of a portion surrounded by said second well region (37) of said epitaxial layer (23).

5. A device according to claim 4, characterized in that said MOS transistor (36) of the first conductivity type is separated from said MOS transistor (30) of the second conductivity type by said second buried diffusion layer (22-2) and said second well region (37).

6. A device according to claim 4, characterized in that backgate voltages of said MOS transistor (36) of the first conductivity type and said MOS transistor (30) of the second conductivity type are changeable.

7. A MOS semiconductor device characterized by comprising:

a semiconductor substrate (41) of a first conductivity type;

a buried diffusion layer (42) of the second conductivity type formed on said substrate (41);

an epitaxial layer (43) of the first conductivity type formed on said substrate (4) and said buried diffusion layer (42);

at least two well regions (44-1, 44-2) of the second conductivity type formed in said epitaxial layer (43) to be in contact with said buried diffusion layer (42);

a MOS transistor (50-1, 50-2) of the first conductivity type formed in a surface layer of said well region (44-1, 44-2)); and

a MOS transistor (56-1, 56-2) of the second conductivity type formed in a surface layer of said epitaxial layer (43).

8. A device according to claim 7, characterized in that said MOS transistor (50-1, 50-2) of the first conductivity type and said MOS transistor (56-1, 56-2) of the second conductivity type are alternately formed.

9. A device according to claim 7, characterized in that said MOS transistor (50-1, 50-2) of the first conductivity type is separated from said MOS transistor (56-1, 56-2) of the second conductivity type by said buried diffusion layer (42) and said well region (44-1, 44-2).

10. A device according to claim 7, characterized in that backgate voltages of said MOS transistor (50-1, 50-2) of the second conductivity type and said MOS transistor (56-1, 56-2) of the first conductivity type are changeable.

F I G. 1

F I G. 2

F I G. 3

F I G. 4

F I G. 5

F I G. 6

F I G. 7

F I G. 8

EP 0 452 874 A2

**FIG. 9**

36

35 31 33 34 32
GND B.G S G D GND

29 25 27 28 26
B.G S G D

30

37

Pwell
23
Nepi
P+ N+ P+ P+ P+
P+
Nepi
Pwell
22-2
23
Pwell
22-2
23
Nepi
P+
Nepi
P+
P+
22-1
24
23
Nepi

P-sub
21

**FIG. 10**

50-1
49 45 47 48 46
B.G S G D

56-1
55 51 53 54 52
B.G S G D

50-2
49 45 47 48 46
B.G S G D

56-2
55 51 53 54 52
B.G S G D

43

N+ P+ P+
Nwell
P+
Pepi
N+ N+
N+
Nwell
P+ P+
P+
Pepi
N+ N+
43

Pepi
N+
44-1
43
44-2
42

P-Sub
41